# DEMANDE DE BREVET EUROPEEN

(11) **EP 1 705 718 A1**
(43) Date de publication de la demande: **27.09.2006**
(21) Numéro de dépôt: 06111637.2
(22) Date de dépôt: 23.03.2006
(51) Int. Cl.: H01L 31/042, H01L 31/05

(54) **Generateur solaire photovoltaique a propagation de courant de decharge limitee**

(30) Priorité: 24.03.2005 FR 0550768
(71) Demandeur: ALCATEL, 75008 Paris (FR)
(72) Inventeur: Boulanger, Bernard, 83600 Frejus (FR)
(74) Mandataire: Hedarchet, Stéphane

(57) **Abrégé**

Un générateur solaire (GS) comprend au moins deux branches (B1 à B4) raccordées électriquement en parallèle par des première (E1) et seconde (E2) extrémités opposées, de polarités respectives positive et négative, et comportant chacune i) une ou plusieurs cellules photoélectriques (C11 à C1N - C41 à C4N), raccordées électriquement en série, ii) une première extrémité (E1) munie de premiers moyens de blocage (MB11-MB41) chargés de bloquer un courant électrique provenant d'une branche voisine, et iii) une seconde extrémité (E2) munie de seconds moyens de blocage (MB12-MB42) chargés de limiter la propagation vers une branche voisine d'un courant de décharge, induit par un arc électrique au niveau d'une cellule photoélectrique de leur propre branche, à une valeur inférieure ou égale à la valeur de courant nominal de cette branche.

## Description

L'invention concerne le domaine des générateurs solaires, et notamment ceux qui sont embarqués sur des engins spatiaux, comme par exemple des satellites.

Certains générateurs solaires comprennent des branches qui sont raccordées électriquement en parallèle par des première et seconde extrémités opposées, de polarités respectives positive et négative, et comportent chacune une ou plusieurs cellules photoélectriques recouvertes chacune sur leur face avant d'une fenêtre (ou écran ou encore filtre) de protection et raccordées électriquement en série.

Les fenêtres (ou écrans) de protection sont destinées à protéger les cellules photoélectriques de certains rayonnements, comme par exemple des flux de protons et/ou d'électrons, afin de leur garantir une certaine durée de vie. Ces fenêtres (ou écrans) de protection devant laisser passer les photons, elles sont généralement réalisées dans un matériau en verre (par exemple de type « coverglass »). Ce matériau n'étant pas conducteur, il a tendance à se charger, ce qui provoque parfois localement un arc électrique dit primaire (ou décharge électrostatique (ESD)) entre une fenêtre de protection et la cellule photoélectrique qu'il recouvre ou une cellule photoélectrique voisine.

Il a été observé que cet arc primaire était constitué de deux parties.

Une première partie, connue sous le terme anglais « blow-off », se présente sous la forme d'un courant induit par la décharge rapide de la capacité générale du système sur lequel est installé le générateur solaire, par exemple un satellite.

Une seconde partie, connue sous le terme anglais « flash-over », se présente sous la forme d'un courant induit par la décharge lente des fenêtres de protection de certaines au moins des cellules photoélectriques, selon un mécanisme de propagation de proche en proche dont la vitesse est de l'ordre de 10⁴ m/s. Ce mécanisme de propagation se fait non seulement des fenêtres de protection des cellules d'une branche vers la fenêtre de protection de la cellule objet de l'arc primaire en raison du plasma qui se crée entre les fenêtres de protection des cellules, mais également des fenêtres de protection des cellules des branches voisines vers la fenêtre de protection de la cellule objet de l'arc primaire en raison dudit plasma et de la circulation du courant de décharge lente de la branche objet de l'arc vers les branches voisines, via leurs liaisons électriques. La circulation du courant de décharge lente se fait généralement via les secondes extrémités des branches, de polarité négative, étant donné que leurs premières extrémités sont généralement pourvues de moyens de blocage de courant, tels que des diodes.

Ce flash-over (ou décharge lente) peut entraîner une dégradation de certaines cellules photoélectriques lorsque sa durée dépasse un seuil qui dépend du matériau dans lequel sont réalisées ces cellules photoélectriques. C'est notamment le cas lorsque les cellules photoélectriques sont réalisées dans un matériau semiconducteur tel que l'Arséniure de Gallium (ou AsGa) et que la durée du flash-over (ou décharge lente) est supérieure à environ 100 *µ*s. Cette dégradation entraîne une diminution de la durée de vie des cellules photoélectriques (et donc une réduction de leur fiabilité), ce qui est particulièrement ennuyeux lorsqu'elles ne peuvent pas être remplacées.

L'invention a donc pour but de remédier à l'inconvénient précité.

Elle propose à cet effet un générateur solaire comprenant au moins deux branches raccordées électriquement en parallèle par des première et seconde extrémités opposées, de polarités respectives positive et négative, et comportant chacune une ou plusieurs cellules photoélectriques, raccordées électriquement en série et revêtues chacune d'une fenêtre de protection, et une première extrémité munie de premiers moyens de blocage chargés de bloquer un courant électrique provenant d'une branche voisine.

Ce générateur solaire se caractérise par le fait que la seconde extrémité de chacune de ses branches est munie de seconds moyens de blocage chargés de limiter la propagation vers une branche voisine d'un courant de décharge (flash-over), induit par un arc électrique survenu au niveau d'une cellule photoélectrique de leur propre branche, à une valeur inférieure ou égale à la valeur du courant nominal de cette branche.

Le générateur solaire selon l'invention peut comporter d'autres caractéristiques qui peuvent être prises séparément ou en combinaison, et notamment :
- les seconds moyens de blocage de chacune de ses branches peuvent comprendre au moins une diode de blocage. Par exemple, les seconds moyens de blocage de chaque branche comprennent au moins deux diodes de blocage raccordées électriquement en parallèle ;
- les premiers moyens de blocage de chacune de ses branches peuvent comprendre au moins une diode de blocage. Par exemple, les premiers moyens de blocage de chaque branche comprennent au moins deux diodes de blocage raccordées électriquement en parallèle ;
- ses cellules photoélectriques peuvent être réalisées en matériau semiconducteur, et par exemple en Arséniure de Gallium (AsGa) ;
- les cellules photoélectriques peuvent présenter une taille qui correspond à une valeur de courant nominal de branche inférieure à une valeur seuil de courant nominal induisant une extinction d'arc ;
- ses branches peuvent être subdivisées en au moins deux sous-parties reliées électriquement et séparées physiquement par l'une des sous-parties d'une branche voisine.

L'invention est particulièrement bien adaptée, bien que de façon non exclusive, aux engins spatiaux, et notamment aux satellites.

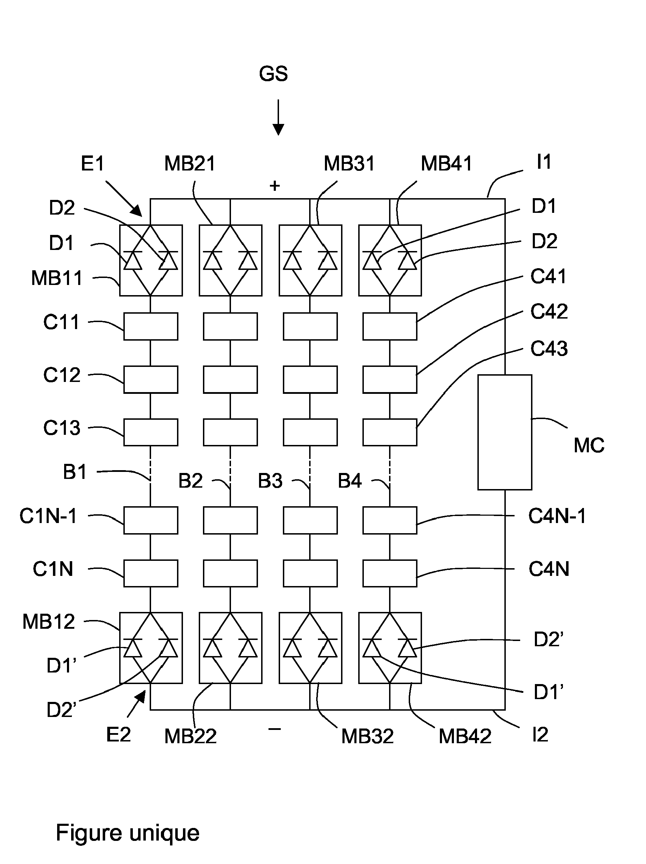

D'autres caractéristiques et avantages de l'invention apparaîtront à l'examen de la description détaillée ci-après, et du dessin annexé, sur lequel l'unique figure illustre de façon très schématique un exemple de réalisation d'un générateur solaire selon l'invention. Le dessin annexé pourra non seulement servir à compléter l'invention, mais aussi contribuer à sa définition, le cas échéant.

L'invention a pour objet de permettre la limitation de la propagation des courants de décharge lente (ou flash-over) dans un générateur solaire.

Dans ce qui suit, on considère à titre d'exemple non limitatif que le générateur solaire est destiné à être implanté sur un engin spatial, comme par exemple un satellite. Mais, l'invention n'est pas limitée à cette application. Elle concerne en effet tout type d'engin ou système équipé d'au moins un générateur solaire susceptible d'être le siège d'arcs électriques.

Comme cela est illustré sur l'unique figure, l'invention propose un générateur solaire GS comprenant au moins deux branches Bi raccordées électriquement en parallèle par des première E1 et seconde E2 extrémités opposées, dont les polarités respectives sont positive (+) et négative (-), et comportant chacune une ou plusieurs cellules photoélectriques Cij, comprenant chacune une face avant recouverte d'une fenêtre (ou écran) de protection (par exemple de type « coverglass ») et raccordées électriquement en série.

Dans l'exemple illustré le générateur solaire GS comprend quatre (i=1 à 4) branches B1 à B4. Mais, un générateur solaire GS selon l'invention peut comporter n'importe quel nombre de branches, dès lors que ce nombre est supérieur ou égal à 2.

Par ailleurs, dans l'exemple illustré chaque branche Bi comprend N cellules photoélectriques Cij, où j = 1 à N. Par exemple N est égal à 16. Mais, chaque branche Bi peut comporter n'importe quel nombre N de cellules photoélectriques Cij, dès lors que ce nombre N est supérieur ou égal à 1.

Les premières E1 et secondes E2 extrémités des branches Bi sont respectivement reliées à un module de conditionnement de puissance (ou PCU pour « Power Conditioning Unit »)) MC via des premières 11 et secondes 12 connections réalisées par câblage.

Dans ce qui suit la référence Cij désigne aussi bien une cellule photoélectrique qu'un ensemble constitué d'une cellule photoélectrique et d'une fenêtre de protection.

Par ailleurs, on considère dans ce qui suit que les cellules photoélectriques Cij sont réalisées en matériau semiconducteur, comme par exemple l'Arséniure de Gallium (AsGa). Mais, l'invention concerne tout type de cellule photoélectrique susceptible d'être le siège d'arcs électriques primaires, selon la définition donnée dans la partie introductive.

Conformément à l'invention, d'une part, la première extrémité E1 (de polarité positive) de chaque branche Bi comprend un premier module de blocage MBi1 chargé de bloquer un courant électrique provenant d'une branche voisine Bi' (i' ≠ i), et d'autre part, la seconde extrémité E2 (de polarité négative) de chaque branche Bi comprend un second module de blocage MBi2 chargé de limiter la propagation vers une branche voisine Bi' (i' ≠ i) d'un courant de décharge de type flash-over, induit par un arc électrique survenant au niveau d'une cellule de la branche Bi à laquelle il appartient, à une valeur inférieure ou égale à la valeur du courant nominal de cette branche Bi.

Ainsi, quand un courant de décharge est induit par un arc électrique au niveau d'une cellule photoélectrique Cij d'une branche Bi, il circule en direction de la seconde extrémité E2 de cette branche Bi et parvient au niveau de son second module de blocage MBi2. Ce dernier étant bloquant pour ledit courant de décharge, le courant nominal de la branche Bi est alors compensé par le courant de décharge qui passe par lui. Autrement dit, le courant de décharge qui passe par le second module de blocage MBi2 (bloquant) est limité à la valeur du courant nominal de la branche concernée Bi.

Dans le cas d'une cellule photoélectrique Cij en Arséniure de Gallium (AsGa), le courant nominal d'une branche Bi est compris entre environ 0 A et environ 0,5 A selon la taille de la cellule photoélectrique Cij.

Par conséquent, le courant de décharge qui parvient au niveau d'une branche Bi', voisine d'une branche Bi dans laquelle l'une des cellules photoélectriques Cij est l'objet d'un arc électrique, est réduit. Cette réduction est destinée à permettre l'extinction de l'arc avant que le plasma ne se propage trop loin. Les seconds modules de blocage MBi2 viennent donc perturber le mécanisme de propagation des décharges des fenêtres de protection des cellules photoélectriques Ci'j des branches Bi' voisines de la branche Bi où l'arc se produit. On limite ainsi la propagation de la décharge à une faible distance du lieu où se produit l'arc, ce qui revient à dire que la durée pendant laquelle l'arc est entretenu devient inférieure à la durée seuil au-delà de laquelle une cellule photoélectrique peut être endommagée (égale à environ 100 µs dans le cas d'une cellule photoélectrique en Arséniure de Gallium). De ce fait, les cellules photoélectriques ne risquent pas d'être endommagées par des arcs électriques.

Il est important de noter que les contributions des fenêtres de protection des cellules photoélectriques Cij' d'une branche Bi à l'entretien d'un arc, survenu au niveau d'une autre cellule photoélectrique Cij de cette même branche Bi, peut être réduite en utilisant une architecture de générateur solaire du type de celle décrite dans les documents brevets EP 1373071 et US 2004/0112419. Dans cette architecture, les branches sont subdivisées en au moins deux sous-parties reliées électriquement et séparées physiquement par l'une des sous-parties d'une branche voisine. Le mécanisme de propagation de décharge peut alors être restreint à une sous-partie de branche, et non à l'intégralité de la branche.

La taille des cellules photoélectriques Cij fixant la valeur du courant nominal d'une branche Bi, il est donc possible de choisir la taille des cellules photoélectriques en fonction de la valeur seuil du courant nominal permettant d'éteindre un arc. En d'autres termes, connaissant la valeur seuil du courant nominal en deçà de laquelle l'arc d'une branche Bi s'éteint (du fait qu'il n'est plus entretenu par les branches voisines Bi'), on choisit une taille de cellule photoélectrique qui fixe un courant nominal de branche inférieur à cette valeur seuil.

Par exemple, et comme illustré sur l'unique figure, chaque premier module de blocage MBi1 est constitué de deux diodes de blocage D1 et D2 montées en parallèle. Mais, cela n'est pas obligatoire. En effet, chaque premier module de blocage MBi1 peut être constitué d'une diode de blocage ou de plusieurs diodes de blocage montées en série et/ou en parallèle. L'utilisation d'au moins deux diodes D1 et D2 montées en parallèle confère une meilleure fiabilité. D'une manière générale, chaque premier module de blocage MBi1 peut être constitué par n'importe quel composant ou ensemble de composants capable de bloquer les courants photoélectriques générés par les cellules photoélectriques Ci'j des branches voisine Bi' (i' ≠ i). Par conséquent, un premier module de blocage MBi1 peut par exemple se présenter sous la forme d'une combinaison de transistors.

Par ailleurs, et comme illustré sur l'unique figure, chaque second module de blocage MBi2 peut par exemple être constitué de deux diodes de blocage D1' et D2' montées en parallèle. Mais, cela n'est pas obligatoire. En effet, chaque second module de blocage MBi2 peut être constitué d'une diode de blocage ou de plusieurs diodes de blocage montées en série et/ou en parallèle. L'utilisation d'au moins deux diodes D1' et D2' montées en parallèle confère une meilleure fiabilité. D'une manière générale, chaque second module de blocage MBi2 peut être constitué par n'importe quel composant ou ensemble de composants capable de bloquer (selon le sens défini précédemment) au moins en partie les courants de décharge (flash over) provenant de l'une des cellules photoélectriques Cij de sa propre branche Bi, afin que seul un courant de valeur au plus égale à la valeur du courant nominal de sa branche Bi puisse éventuellement circuler vers les branches voisines Bi' (i' # i) via leurs secondes extrémités E2 respectives et les liaisons électriques qui les relient. Par conséquent, un second module de blocage MBi2 peut par exemple se présenter sous la forme d'une combinaison de transistors.

Les diodes D1' et D2' peuvent être identiques ou différentes des diodes D1 et D2.

Le temps de réaction des diodes de blocage (ici D1' et D2') d'un second module de blocage MBi2 est de l'ordre de 150 ns, ce qui est suffisamment faible pour limiter la propagation du courant de décharge (flash-over) à environ 2 mm entre deux cellules photoélectriques Cij et Cij' (j' ≠ j), lorsque la vitesse de propagation est de l'ordre de 10⁴ m/s.

L'invention ne se limite pas aux modes de réalisation de générateur solaire GS décrits ci-avant, seulement à titre d'exemple, mais elle englobe toutes les variantes que pourra envisager l'homme de l'art dans le cadre des revendications ci-après.

## Revendications

1. Générateur solaire (GS) comprenant au moins deux branches (Bi) raccordées électriquement en parallèle par de première (E1) et seconde (E2) extrémités opposées de polarités respectives positive et négative, chaque branche (Bi) comportant une ou plusieurs cellules photoélectriques (Cij), raccordées électriquement en série et revêtues chacune d'une fenêtre de protection, et présentant une première extrémité (E1) munie de premiers moyens de blocage (MBi1) propres à bloquer un courant électrique provenant d'une branche voisine (Bi'), **caractérisé en ce que** la seconde extrémité (E2) de chaque branche (Bi) est munie de seconds moyens de blocage (MBi2) propres à limiter la propagation vers une branche voisine (Bi') d'un courant de décharge, induit par un arc électrique survenu au niveau d'une cellule photoélectrique (Cij) de leur propre branche (Bi), à une valeur inférieure ou égale à une valeur de courant nominal de cette branche (Bi).

2. Générateur solaire selon la revendication 1, **caractérisé en ce que** lesdits seconds moyens de blocage (MBi2) de chaque branche (Bi) comprennent au moins une diode de blocage (D1,D2).

3. Générateur solaire selon la revendication 2, **caractérisé en ce que** lesdits seconds moyens de blocage (MBi2) de chaque branche (Bi) comprennent au moins deux diodes de blocage (D1',D2') raccordées électriquement en parallèle.

4. Générateur solaire selon l'une des revendications 1 à 3, **caractérisé en ce que** lesdits premiers moyens de blocage (MBi1) de chaque branche (Bi) comprennent au moins une diode de blocage (D1,D2).

5. Générateur solaire selon la revendication 4, **caractérisé en ce que** lesdits premiers moyens de blocage (MBi1) de chaque branche (Bi) comprennent au moins deux diodes de blocage (D1,D2) raccordées électriquement en parallèle.

6. Générateur solaire selon l'une des revendications 2 à 5, **caractérisé en ce que** lesdites cellules photoélectriques (Cij) sont réalisées en matériau semiconducteur.

7. Générateur solaire selon la revendication 6, **caractérisé en ce que** lesdites cellules photoélectriques (Cij) sont réalisées en Arséniure de Gallium (AsGa).

8. Générateur solaire selon l'une des revendications 1 à 7, **caractérisé en ce que** lesdites cellules photoélectriques (Cij) présentent une taille correspondant à une valeur de courant nominal de branche (Bi) inférieure à une valeur seuil de courant nominal induisant une extinction d'arc.

9. Générateur solaire selon l'une des revendications 1 à 8, **caractérisé en ce que** lesdites branches (Bi) sont subdivisées en au moins deux sous-parties reliées électriquement et séparées physiquement par l'une des sous-parties d'une branche voisine (Bi').

10. Engin spatial, **caractérisé en ce qu'**il comprend au moins un générateur solaire (GS) selon l'une des revendications précédentes.
